# EUROPÄISCHE PATENTSCHRIFT

(11) **EP 1 212 770 B1**
(45) Veröffentlichungstag und Bekanntmachung des Hinweises auf die Patenterteilung: **19.02.2003**
(21) Anmeldenummer: 00963865.1
(22) Anmeldetag: 31.07.2000
(51) Int. Cl.: H01H 47/00

(54) **ÜBERWACHUNGSVERFAHREN FÜR EIN ELEKTROMAGNETISCHES SCHALTGERÄT UND HIERMIT KORRESPONDIERENDES ELEKTROMAGNETISCHES SCHALTGERÄT**
CONTROL SYSTEM FOR AN ELECTROMAGNETIC SWITCHING DEVICE AND ELECTROMAGNETIC SWITCHING DEVICE CORRESPONDING THERETO
PROCEDE DE SURVEILLANCE POUR UN APPAREIL DE COMMUTATION ELECTROMAGNETIQUE, ET APPAREIL DE COMMUTATION ELECTROMAGNETIQUE CORRESPONDANT

(30) Priorität: 16.09.1999 DE 19944461
(43) Veröffentlichungstag der Anmeldung: 12.06.2002
(73) Patentinhaber: SIEMENS AKTIENGESELLSCHAFT, 80333 München (DE)
(72) Erfinder: STREICH, Bernhard, 92224 Amberg (DE); MITLMEIER, Norbert, 92289 Ursensollen (DE)
(86) Internationale Anmeldenummer: DE0002522
(87) Internationale Veröffentlichungsnummer: WO01020630

(56) Entgegenhaltungen:
- EP-A- 0 660 348

## Beschreibung

Die vorliegende Erfindung betrifft ein Überwachungsverfahren für ein elektromagnetisches Schaltgerät zumindest auf ordnungsgemäßes Verbinden eines Eingangs- und eines Ausgangskontakts durch eine Kontaktbrücke, wobei bei ordnungsgemäßem Verbinden der Kontakte die Kontaktbrücke mittels eines Brükkenantriebs bei Vorgabe eines Verbindungsbefehls von einer Trenn- in eine Verbindungsposition überführt wird, sowie ein hiermit korrespondierendes elektromagnetisches Schaltgerät.

Elektromagnetische Schaltgeräte, also Schütze und Relais, sind allgemein bekannt. Sie weisen mindestens einen Eingangsund einen Ausgangskontakt auf, die durch eine Kontaktbrücke miteinander verbunden bzw. voneinander getrennt werden. Neben dem normalen Verschleiß können im wesentlichen zwei Störungen auftreten. Die eine Störung ist das Brechen der Kontaktbrükke. In diesem Fall können die Kontakte nicht mehr ordnungsgemäß miteinander verbunden werden. Die andere Störung ist das Verschweißen der Kontaktbrücke mit den Kontakten. In diesem Fall können die Kontakte nicht mehr ordnungsgemäß voneinander getrennt werden. Insbesondere eine gebrochene Brücke kann zur Zerstörung des gesamten elektromagnetischen Schaltgeräts und auch zu Störungen in einer angeschlossenen Anlage führen.

Selbstverständlich ist es möglich, das elektromagnetische Schaltgerät in einer Testschaltung auf ordnungsgemäßes Funktionieren zu überprüfen. Dieser Test erfolgt aber in einer Testschaltung. Eine kontinuierliche Überwachung des elektromagnetischen Schaltgeräts während des Betriebs ist damit nicht möglich.

Die Aufgabe der vorliegenden Erfindung besteht darin, ein Überwachungsverfahren für ein elektromagnetisches Schaltgerät und ein hiermit korrespondierendes elektromagnetisches Schaltgerät zu schaffen, mittels derer das elektromagnetische Schaltgerät im laufenden Betrieb zumindest auf ordnungsgemäßes Verbinden der Kontakte überwachbar ist.

Die Aufgabe wird für das Überwachungsverfahren dadurch gelöst, daß bei Vorgabe des Verbindungsbefehls vor dem Überführen der Kontaktbrücke in die Verbindungsposition eine Überwachungsschaltung an die Kontakte angekoppelt wird und durch Auswertung einer über den Kontakten abfallenden, der Überwachungsschaltung zugeführten Kontaktspannung ein Indikator für das ordnungsgemäße Verbinden der Kontakte ermittelt wird.

Hiermit korrespondierend wird die Aufgabe für das elektromagnetische Schaltgerät dadurch gelöst,
- daß eine Überwachungsschaltung über einen Hilfsschalter an die Kontakte ankoppelbar ist,
- daß der Hilfsschalter derart ausgebildet ist, daß bei Vorgabe eines Verbindungsbefehls der Hilfsschalter vor dem Überführen der Kontaktbrücke in die Verbindungsposition geschlossen wird, und
- daß die Überwachungsschaltung einen Indikator für das ordnungsgemäße Verbinden der Kontakte abgibt.

Wenn bei ordnungsgemäßem Trennen der Kontakte die Kontaktbrücke mittels des Brückenantriebs bei Vorgabe eines Trennbefehls von der Verbindungs- in die Trennposition überführt wird, bei Vorgabe eines Trennbefehls nach dem Überführen der Kontaktbrücke in die Trennposition die Überwachungsschaltung von mindestens einem der Kontakte abgekoppelt wird und durch Auswertung der Kontaktspannung ein Indikator für das ordnungsgemäße Trennen der Kontakte ermittelt wird, kann das elektromagnetische Schaltgerät auch auf ordnungsgemäßes Trennen des Eingangs- von dem Ausgangskontakt durch die Kontaktbrücke überwacht werden.

Wenn die Kontaktspannung vor dem Zuführen zur Überwachungsschaltung gleichgerichtet wird, ist die Überwachungsschaltung unabhängig von der Art und gegebenenfalls Polung der geschalteten Spannung einsetzbar.

Wenn ein mit der Kontaktspannung korrespondierendes Vorsignal einer Auswerteeinheit zugeführt wird, die den Indikator ermittelt, ist die Ermittlung des Indikators besonders einfach.

Wenn das Vorsignal der Auswerteeinheit galvanisch getrennt zugeführt wird, kann die Auswerteeinheit besonders einfach in eine übergeordnete Steuerung und/oder die Schützsteuerung eingegliedert werden. Insbesondere ist es möglich, bei nicht ordnungsgemäßem Verbinden bzw. Trennen der Kontakte das elektromagnetische Schaltgerät in einen sicheren Zustand zu überführen. Alternativ oder zusätzlich dazu ist es möglich, bei nicht ordnungsgemäßem Verbinden bzw. Trennen der Kontakte das nicht ordnungsgemäße Verbinden bzw. Trennen der Kontakte an eine übergeordnete Steuerung zu melden.

Weitere Vorteile und Einzelheiten ergeben sich aus der nachfolgenden Beschreibung eines Ausführungsbeispiels. Dabei zeigen in Prinzipdarstellung
- FIG 1: ein elektromagnetisches Schaltgerät mit einer Überwachungsschaltung und
- FIG 2 - 4: je ein Schaltdiagramm des elektromagnetischen Schaltgeräts und einen Vorsignalverlauf.

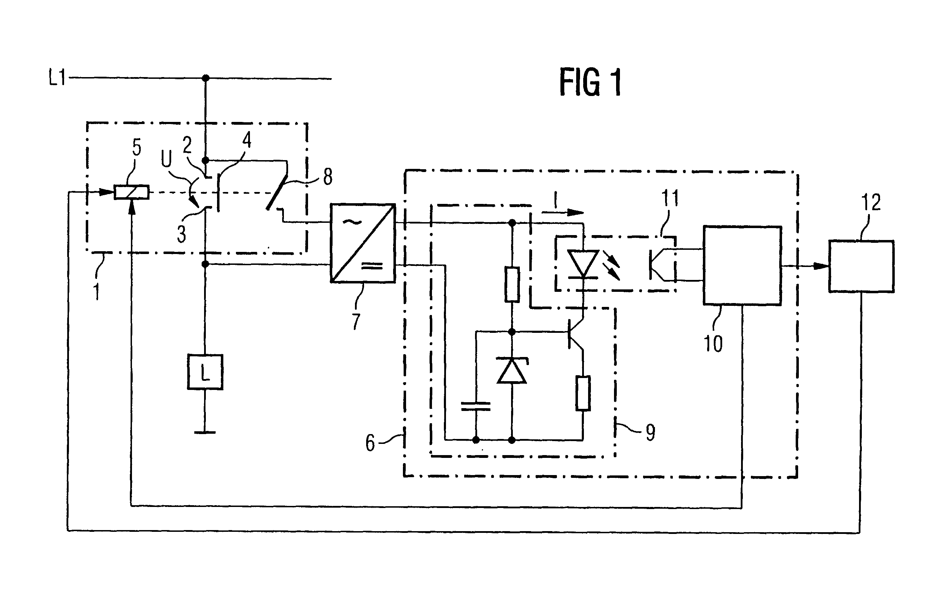

Gemäß FIG 1 ist ein elektromagnetisches Schaltgerät 1 als Schütz ausgebildet. Es weist mindestens einen Eingangskontakt 2 und einen hiermit korrespondierenden Ausgangskontakt 3 sowie eine Kontaktbrücke 4 auf. Bei ordnungsgemäßem Funktionieren des elektromagnetischen Schaltgeräts 1 wird die Kontaktbrücke 4 bei Vorgabe eines Verbindungsbefehls von einer Trenn- in eine Verbindungsposition überführt. Bei Vorgabe eines Trennbefehls wird die Kontaktbrücke 4 von der Verbindungs- in die Trennposition überführt. In der Verbindungsposition der Kontaktbrücke 4 sind die Kontakte 2, 3 miteinander verbunden. In der Trennposition sind sie voneinander getrennt. Das Überführen der Kontaktbrücke 4 von der Trenn- in die Verbindungsposition und umgekehrt erfolgt mittels eines Brückenantriebs 5.

Zum Überwachen des elektromagnetischen Schaltgeräts 1 auf ordnungsgemäßes Verbinden und Trennen der Kontakte 2, 3 weist das elektromagnetische Schaltgerät 1 eine Überwachungsschaltung 6 auf. Der Überwachungsschaltung 6 ist ein Gleichrichter 7 vorgeordnet. Dem Gleichrichter 7 wiederum ist ein Hilfsschalter 8 vorgeordnet. Mittels des Hilfsschalters 8 ist die Überwachungsschaltung 6 an die Kontakte 2, 3 ankoppelbar sowie von dem Eingangskontakt 2 abkoppelbar. Wenn der Hilfsschalter 8 geschlossen ist, wird der Überwachungsschaltung 6 eine Kontaktspannung U zugeführt, die über den Kontakten 2, 3 abfällt. Aufgrund des Vorhandenseins des Gleichrichters 7 wird die Kontaktspannung U der Überwachungsschaltung 6 dabei gleichgerichtet zugeführt.

Der Hilfsschalter 8 ist derart ausgebildet, daß er beim Überführen der Kontaktbrücke 4 in die Verbindungsposition voreilt und beim Überführen der Kontaktbrücke 4 in die Trennposition nacheilt. Der Hilfsschalter 8 wird also bei Vorgabe eines Verbindungsbefehls vor dem Überführen der Kontaktbrücke 4 in die Verbindungsposition geschlossen. Bei Vorgabe eines Trennbefehls wird der Hilfsschalter 8 hingegen erst nach dem Überführen der Kontaktbrücke 4 in die Trennposition geöffnet. Es wird also die Überwachungsschaltung 6 bei Vorgabe des Verbindungsbefehls vor dem Überführen der Kontaktbrücke 4 in die Verbindungsposition an die Kontakte 2, 3 angekoppelt. Bei Vorgabe eines Trennbefehls wird sie erst nach dem Überführen der Kontaktbrücke 4 in die Trennposition von dem Eingangskontakt 2 abgekoppelt. Dadurch ist es möglich, daß die Überwachungsschaltung 6 durch Auswertung der ihr zugeführten Kontaktspannung U einen Indikator für das ordnungsgemäße Verbinden bzw. Trennen der Kontakte 2, 3 ermittelt. Der Indikator kann dann von der Überwachungsschaltung 6 abgegeben werden.

Aufgrund der Gleichrichtung der Kontaktspannung U kann die Ausbildung der Überwachungsschaltung 6 unabhängig von der Polung der zu schaltenden Spannung sein und auch unabhängig davon, ob die zu schaltende Spannung eine Gleich- oder eine Wechselspannung ist.

Gemäß FIG 1 weist die Überwachungsschaltung 6 einen Kontaktspannungsindikator 9 und eine Auswerteeinheit 10 auf. Der Kontaktspannungsindikator 9 ist gemäß FIG 1 als Konstantstromquelle ausgebildet. Der Kontaktspannungsindikator 9 gibt also bei Vorliegen einer Kontaktspannung U unabhängig von deren Höhe einen Konstantstrom I aus. Der Konstantstrom I stellt somit ein mit der Kontaktspannung U korrespondierendes Vorsignal dar.

Das Vorsignal wird der Auswerteeinheit 10 über einen Optokoppler 12 galvanisch getrennt zugeführt. Die Auswerteeinheit 10 ermittelt dann den Indikator für das Trennen bzw. Verbinden der Kontakte 2, 3.

Es ist möglich, daß die Auswerteeinheit 10 das Vorliegen bzw. Nichtvorliegen eines ordnungsgemäßen Betriebs des Schaltgeräts 1 lediglich über eine Anzeige, z. B. eine Leuchtdiode, anzeigt. In diesem Fall muß bei einem nicht ordnungsgemäßen Funktionieren des Schaltgeräts 1 ein manueller Eingriff durch eine Bedienperson erfolgen. Vorzugsweise aber ist die Auswerteeinheit 10 mit dem Brückenantrieb 5 steuerungstechnisch verbunden. In diesem Fall ist es möglich, daß bei nicht ordnungsgemäßen Verbinden bzw. Trennen der Kontakte 2, 3 das elektromagnetische Schaltgerät 1 in einen sicheren Zustand überführt wird.

Alternativ oder zusätzlich kann die Auswerteeinheit 10 auch mit einer übergeordneten Steuerung 12 kommunikativ verbunden sein. In diesem Fall kann bei nicht ordnungsgemäßen Verbinden bzw. Trennen der Kontakte 2, 3 eine entsprechende Meldung an die übergeordnete Steuerung 12 übermittelt werden.

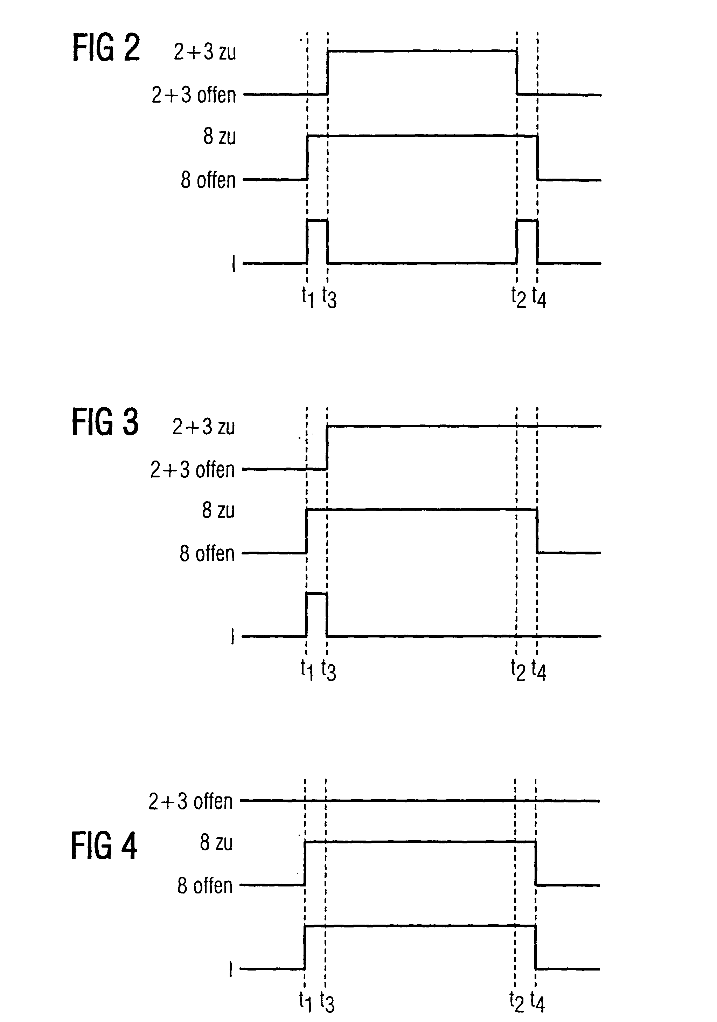

Die FIG 2 bis 4 zeigen, wie das vom Optokoppler 11 an die Auswerteeinheit 10 übermittelte Vorsignal ausgewertet werden kann.

Gemäß den FIG 2 bis 4 wird zu einem Zeitpunkt t1 dem elektromagnetischen Schaltgerät 1 ein Verbindungsbefehl vorgegeben, zu einem Zeitpunkt t2 ein Trennbefehl. Mit Vorgabe des Verbindungsbefehls wird gleichzeitig bzw. unmittelbar darauffolgend der Hilfsschalter 8 geschlossen. Die Kontakte 2, 3 hingegen werden bei ordnungsgemäßen Betrieb gemäß den FIG 2 und 3 erst später, nämlich zu einem Zeitpunkt t3, geschlossen. Über den Optokoppler 11 wird daher gemäß den FIG 2 und 3 zwischen den Zeitpunkten t1 und t3 ein Vorsignal abgegeben, danach nicht mehr. Wenn hingegen, wie in FIG 4 dargestellt, die Kontaktbrücke 4 gebrochen ist oder aus anderen Gründen die Kontakte 2, 3 nicht miteinander verbunden werden, übermittelt der Optokoppler 11 ab dem Zeitpunkt t1 ein Dauersignal. Das Auftreten eines Dauersignals kann also als Indikator für eine gebrochene Kontaktbrücke 4 herangezogen werden.

Nach der Vorgabe des Trennbefehls werden die Kontakte 2, 3 sofort wieder voneinander getrennt, der Hilfsschalter 8 hingegen erst zu einem Zeitpunkt t4. Bei ordnungsgemäßen Betrieb des Schaltgeräts 1 gemäß FIG 2 wird daher zwischen den Zeitpunkten t3 und t4 wieder ein Vorsignal an die Auswerteeinheit 10 übermittelt.

Wenn hingegen, wie in FIG 3 dargestellt, die Kontaktbrücke 4 mit den Kontakten 2, 3 verschweißt, bleibt dieser zweite Impuls aus. Das Ausbleiben des zweiten Impulses kann also als Indikator für ein Nichttrennen der Kontakte 2, 3 herangezogen werden.

Nach dem Öffnen des Hilfsschalters 8 geht selbstverständlich auch bei voneinander getrennten Kontakten 2, 3 das Vorsignal auf Null zurück.

Das obenstehend beschriebene Schaltgerät 1 und das hiermit korrespondierende Überwachungsverfahren können nicht nur bei einphasigen Gleich- und Wechselspannungsnetzen, sondern auch bei mehrphasigen Drehstromnetzen angewendet werden. In diesem Fall ist für jedes Paar eines Eingangs- und Ausgangskontakts 2, 3, die über eine Kontaktbrücke 4 miteinander verbindbar sind, ein eigener Hilfsschalter 8 und ein eigener Kontaktspannungsindikator 9 erforderlich. Die Auswerteeinheit 10 kann wahlweise separat oder allen Phasen gemeinsam sein.

Einer Sternschaltung mit separatem Nullleiter ist eine uneingeschränkte Überwachung der geschalteten Kontakte 2, 3 möglich. Bei einer Dreieckschaltung ist eine uneingeschränkte Überwachung der geschalteten Kontakte 2, 3 auf ordnungsgemäßes Verbinden möglich. Ein Nichttrennen eines von drei Kontakten ist nicht detektierbar, ein Nichttrennen von zwei oder drei Kontaktpaaren hingegen ist auch bei einer Dreieckschaltung detektierbar.

## Patentansprüche

1. Überwachungsverfahren für ein elektromagnetisches Schaltgerät (1) zumindest auf ordnungsgemäßes Verbinden eines Eingangs- (2) und eines Ausgangskontakts (3) durch eine Kontaktbrücke (4), wobei bei ordnungsgemäßem Verbinden der Kontakte (2, 3) die Kontaktbrücke (4) mittels eines Brückenantriebs (5) bei Vorgabe eines Verbindungsbefehls von einer Trenn- in eine Verbindungsposition überführt wird,
**dadurch gekennzeichnet,**
- **daß** bei Vorgabe des Verbindungsbefehls vor dem Überführen der Kontaktbrücke (4) in die Verbindungsposition eine Überwachungsschaltung (6) an die Kontakte (2, 3) angekoppelt wird und
- **daß** durch Auswertung einer über den Kontakten (2, 3) abfallenden, der Überwachungsschaltung (6) zugeführten Kontaktspannung (U) ein Indikator für das ordnungsgemäße Verbinden der Kontakte (2, 3) ermittelt wird.

2. Überwachungsverfahren nach Anspruch 1,
**dadurch gekennzeichnet,**
- **daß** das elektromagnetische Schaltgerät (1) auch auf ordnungsgemäßes Trennen des Eingangs- (2) von dem Ausgangskontakt (3) durch die Kontaktbrücke (4) überwacht wird,
- **daß** bei ordnungsgemäßem Trennen der Kontakte (2, 3) die Kontaktbrücke (4) mittels des Brückenantriebs (5) bei Vorgabe eines Trennbefehls von der Verbindungs- in die Trennposition überführt wird,
- **daß** bei Vorgabe eines Trennbefehls nach dem Überführen der Kontaktbrücke (4) in die Trennposition die Überwachungsschaltung (6) von mindestens einem der Kontakte (2, 3) abgekoppelt wird und
- **daß** durch Auswertung der Kontaktspannung (U) ein Indikator für das ordnungsgemäße Trennen der Kontakte (2, 3) ermittelt wird.

3. Überwachungsverfahren nach Anspruch 1 oder 2,
**dadurch gekennzeichnet,**
**daß** die Kontaktspannung (U) vor dem Zuführen zur Überwachungsschaltung (6) gleichgerichtet wird.

4. Überwachungsverfahren nach Anspruch 1, 2 oder 3,
**dadurch gekennzeichnet,**
**daß** ein mit der Kontaktspannung (U) korrespondierendes Vorsignal (I) einer Auswerteeinheit (10) zugeführt wird, die den Indikator ermittelt.

5. Überwachungsverfahren nach Anspruch 4,
**dadurch gekennzeichnet,**
**daß** das Vorsignal (I) der Auswerteeinheit (10) galvanisch getrennt zugeführt wird.

6. Überwachungsverfahren nach einem der Ansprüche 1 bis 5,
**dadurch gekennzeichnet,**
**daß** bei nicht ordnungsgemäßem Verbinden bzw. Trennen der Kontakte (2, 3) das elektromagnetische Schaltgerät (1) in einen sicheren Zustand überführt wird.

7. Überwachungsverfahren nach einem der Ansprüche 1 bis 6,
**dadurch gekennzeichnet,**
**daß** bei nicht ordnungsgemäßem Verbinden bzw. Trennen der Kontakte (2, 3) das nicht ordnungsgemäße Verbinden bzw. Trennen der Kontakte (2, 3) an eine übergeordnete Steuerung (12) gemeldet wird..

8. Elektromagnetisches Schaltgerät mit mindestens einem Eingangs- (2) und einem Ausgangskontakt (3) und einer Kontaktbrücke (4), wobei die Kontaktbrücke (4) mittels eines Brückenantriebs (5) bei Vorgabe eines Verbindungsbefehls von einer Trenn- in eine Verbindungsposition überführbar ist,
**dadurch gekennzeichnet,**
- **daß** eine Überwachungsschaltung (6) über einen Hilfsschalter (8) an die Kontakte (2, 3) ankoppelbar ist,
- **daß** der Hilfsschalter (8) derart ausgebildet ist, daß bei Vorgabe eines Verbindungsbefehls der Hilfsschalter (8) vor dem Überführen der Kontaktbrücke (4) in die Verbindungsposition geschlossen wird, und
- **daß** die Überwachungsschaltung (6) einen Indikator für das ordnungsgemäße Verbinden der Kontakte (2, 3) abgibt.

9. Schaltgerät nach Anspruch 8,
**dadurch gekennzeichnet,**
- **daß** die Überwachungsschaltung (6) über den Hilfsschalter (8) von mindestens einem der Kontakte (2, 3) abkoppelbar ist,
- **daß** der Hilfsschalter (8) derart ausgebildet ist, daß bei Vorgabe eines Trennbefehls der Hilfsschalter (8) nach dem Überführen der Kontaktbrücke (4) in die Trennposition geöffnet wird, und
- **daß** die Überwachungsschaltung (6) einen Indikator für das ordnungsgemäße Trennen der Kontakte (2, 3) abgibt.

10. Schaltgerät nach Anspruch 8 oder 9,
**dadurch gekennzeichnet,**
**daß** der Überwachungsschaltung (6) ein Gleichrichter (7) vorgeordnet ist.

11. Schaltgerät nach Anspruch 8, 9 oder 10,
**dadurch gekennzeichnet,**
**daß** die Überwachungsschaltung (6) einen Kontaktspannungsindikator (9) und eine Auswerteeinheit (10) aufweist, daß der Kontaktspannungsindikator (9) ein mit der Kontaktspannung (U) korrespondierendes Vorsignal (I) an die Auswerteeinheit (10) ausgibt und daß die Auswerteeinheit (10) den Indikator ermittelt.

12. Schaltgerät nach Anspruch 11,
**dadurch gekennzeichnet,**
**daß** der Kontaktspannungsindikator (9) von der Auswerteeinheit (10) galvanisch getrennt ist.

13. Schaltgerät nach einem der Ansprüche 9 bis 12,
**dadurch gekennzeichnet,**
**daß** die Überwachungsschaltung (6) mit dem Brückenantrieb (5) steuerungstechnisch verbunden ist.

14. Schaltgerät nach einem der Ansprüche 7 bis 13,
**dadurch gekennzeichnet,**
**daß** die Überwachungsschaltung (6) mit einer übergeordneten Steuerung (12) kommunikativ verbunden ist.

## Claims

1. Monitoring method for an electromagnetic switching device (1) at least for the correct connection of an input contact (2) and of an output contact (3) by means of a contact bridge (4), the contact bridge (4) being moved from a separated position into a connection position by means of a bridge drive (5) when a connection command is given, if the contacts (2, 3) are correctly connected,
**characterised in that**
- when the connection command is given, a monitoring circuit (6) is coupled to the contacts (2, 3) before the contact bridge (4) is moved into the connection position, and
- an indicator of the correct connection of the contacts (2, 3) is determined by evaluation of a contact voltage (U) dropped across the contacts (2, 3) and supplied to the monitoring circuit (6).

2. Monitoring method according to Claim 1, **characterised in that**
- the electromagnetic switching device (1) is also monitored for correct separation of the input contact (2) from the output contact (3) by the contact bridge (4),
- if the contacts (2, 3) are correctly separated, the contact bridge (4) is moved from the connection position into the separated position by means of the bridge drive (5) when a separating command is given,
- when a separating command is given, the monitoring circuit (6) is decoupled from at least one of the contacts (2, 3) after the contact bridge (4) has moved into the separated position, and
- an indicator of the correct separation of the contacts (2, 3) is determined by evaluation of the contact voltage (U).

3. Monitoring method according to Claim 1 or 2, **characterised in that** the contact voltage (U) is rectified before it is supplied to the monitoring circuit (6).

4. Monitoring method according to Claim 1, 2 or 3, **characterised in that** a preliminary signal (I) corresponding to the contact voltage (U) is supplied to an evaluating unit (10) which determines the indicator.

5. Monitoring method according to Claim 4, **characterised in that** the preliminary signal (I) is supplied DC-isolated to the evaluating unit (10).

6. Monitoring method according to one of Claims 1 to 5, **characterised in that** the electromagnetic switching device (1) is moved into a safe state if the contacts (2, 3) are not correctly connected or separated, respectively.

7. Monitoring method according to one of Claims 1 to 6, **characterised in that** the incorrect connection or separation of the contacts (2, 3) is signalled to a higher-level controller (12) if the contacts (2, 3) are not correctly connected or separated, respectively.

8. Electromagnetic switching device comprising at least one input contact (2) and one output contact (3) and a contact bridge (4), wherein the contact bridge (4) can be moved from a separated position into a connection position by means of a bridge drive (5) when a connection command is given, **characterised in that**
- a monitoring circuit (6) can be coupled to the contacts (2, 3) via an auxiliary switch (8),
- the auxiliary switch (8) is constructed such that, when a corriection command is given, the auxiliary switch (8) is closed before the contact bridge (4) is moved into the connection position, and
- the monitoring circuit (6) outputs an indicator of the correct connection of the contacts (2, 3).

9. Switching device according to Claim 8, **characterised in that**
- the monitoring circuit (6) can be decoupled from at least one of the contacts (2, 3) via the auxiliary switch (8),
- the auxiliary switch (8) is constructed such that, when a separating command is given, the auxiliary switch (8) is opened after the contact bridge (4) has been moved into the separated position, and
- the monitoring circuit (6) outputs an indicator of the correct separation of the contacts (2, 3).

10. Switching device according to Claim 8 or 9, **characterised in that** the monitoring circuit (6) is preceded by a rectifier (7).

11. Switching device according to Claim 8, 9 or 10, **characterised in that** the monitoring circuit (6) has a contact voltage indicator (9) and an evaluating unit (10), that the contact voltage indicator (9) outputs to the evaluating unit (10) a prelinunary signal (I) corresponding to the contact voltage (U), and that the evaluating unit (10) determines the indicator.

12. Switching device according to Claim 11, **characterised in that** the contact voltage indicator (9) is DC-isolated from the evaluating unit (10).

13. Switching device according to one of Claims 9 to 12, **characterised in that** the monitoring circuit (6) is connected to the bridge drive (5) by control technology.

14. Switching device according to one of Claims 7 to 13, **characterised in that** the monitoring circuit (6) is communicatively connected to a higher-level controller (12).

## Revendications

1. Procédé de surveillance pour un appareil de commutation électromagnétique (1) au moins pour vérifier la liaison normale d'un contact d'entrée (2) et d'un contact de sortie (3) par un pont de contact (4), le pont de contact (4) passant au moyen d'un entraînement de pont (5), lors de la donnée d'une instruction de liaison, d'une position de coupure à une position de liaison si la liaison des contacts (2, 3) est normale,
**caractérisé par le fait que**
- lors de la donnée de l'instruction de liaison, on couple un circuit de surveillance (6) aux contacts (2, 3) avant le passage du pont de contact (4) dans la position de liaison, et
- en évaluant une tension de contact (U) chutant sur les contacts (2, 3) et envoyée au circuit de surveillance (6), on détermine un indicateur de la liaison normale des contacts (2, 3).

2. Procédé de surveillance selon la revendication 1,
**caractérisé par le fait que**
- on surveille aussi l'appareil de commutation électromagnétique (1) pour vérifier la coupure normale entre le contact d'entrée (2) et le contact de sortie (3) par le pont de contact (4),
- si la coupure des contacts (2, 3) est normale, lors de la donnée d'une instruction de coupure, on fait passer le pont de contact (4) de la position de liaison à la position de coupure au moyen de l'entraînement de pont (5),
- lors de la donnée d'une instruction de coupure, on découple le circuit de surveillance (6) au moins de l'un des contacts (2, 3) après le passage du pont de contact (4) dans la position de coupure, et
- en évaluant la tension de contact (U), on détermine un indicateur de la coupure normale des contacts (2, 3).

3. Procédé de surveillance selon la revendication 1 ou 2,
**caractérisé par le fait qu'**on redresse la tension de contact (U) avant de l'envoyer au circuit de surveillance (6).

4. Procédé de surveillance selon la revendication 1, 2 ou 3,
**caractérisé par le fait qu'**on envoie un signal préalable (I), correspondant à la tension de contact (U), à une unité d'évaluation (10) qui détermine l'indicateur.

5. Procédé de surveillance selon la revendication 4,
**caractérisé par le fait qu'**on envoie le signal préalable (I), isolé électriquement, à l'unité d'évaluation (10).

6. Procédé de surveillance selon l'une des revendications 1 à 5,
**caractérisé par le fait que**, en cas de liaison anormale ou de coupure anormale des contacts (2, 3), on fait passer l'appareil de commutation électromagnétique (1) dans un état sûr.

7. Procédé de surveillance selon l'une des revendications 1 à 6,
**caractérisé par le fait que**, en cas de liaison anormale ou de coupure anormale des contacts (2, 3), on signale la liaison anormale ou la coupure anormale des contacts (2, 3) à une commande supérieure (12).

8. Appareil de commutation électromagnétique comportant au moins un contact d'entrée (2) et un contact de sortie (3) ainsi qu'un pont de contact (4), le pont de contact (4) pouvant passer au moyen d'un entraînement de pont (5), lors de la donnée d'une instruction de liaison, d'une position de coupure à une position de liaison,
**caractérisé par le fait que**
- un circuit de surveillance (6) peut être couplé aux contacts (2, 3) par l'intermédiaire d'un interrupteur auxiliaire (8),
- l'interrupteur auxiliaire (8) est conçu de telle sorte que, lors de la donnée d'une instruction de liaison, l'interrupteur auxiliaire (8) est fermé avant le passage du pont de contact (4) dans la position de liaison, et
- le circuit de surveillance (6) délivre un indicateur de la liaison normale des contacts (2, 3).

9. Appareil de commutation selon la revendication 8,
**caractérisé par le fait que**
- le circuit de surveillance (6) peut être découplé au moins de l'un des contacts (2, 3) par l'intermédiaire de l'interrupteur auxiliaire (8),
- l'interrupteur auxiliaire (8) est conçu de telle sorte que, lors de la donnée d'une instruction de coupure, l'interrupteur auxiliaire (8) est ouvert aprés le passage du pont de contact (4) dans la position de coupure, et
- le circuit de surveillance (6) délivre un indicateur de la coupure normale des contacts (2, 3).

10. Appareil de commutation selon la revendication 8 ou 9,
**caractérisé par le fait qu'**un redresseur (7) est monté du côté amont du circuit de surveillance (6).

11. Appareil de commutation selon la revendication 8, 9 ou 10,
**caractérisé par le fait que** le circuit de surveillance (6) comporte un indicateur de tension de contact (9) et une unité d'évaluation (10), que l'indicateur de tension de contact (9) délivre à l'unité d'évaluation (10) un signal préalable (I) correspondant à la tension de contact (U) et que l'unité d'évaluation (10) détermine l'indicateur.

12. Appareil de commutation selon la revendication 11,
**caractérisé par le fait que** l'indicateur de tension de contact (9) est isolé électriquement de l'unité d'évaluation (10).

13. Appareil de commutation selon l'une des revendications 9 à 12,
**caractérisé par le fait que** le circuit de surveillance (6) est relié pour la technique de commande à l'entraînement de pont (5).

14. Appareil de commutation selon l'une des revendications 7 à 13,
**caractérisé par le fait que** le circuit de surveillance (6) est relié pour la communication à une commande supérieure (12).
